# EUROPEAN PATENT SPECIFICATION

(11) **EP 3 529 829 B1**
(45) Date of publication and mention of the grant of the patent: **12.08.2020**
(21) Application number: 17787030.0
(22) Date of filing: 13.10.2017
(51) Int. Cl.: H01L 21/67

(54) **METHOD AND MACHINING APPARATUS**
VERFAHREN UND BEARBEITUNGSVORRICHTUNG
PROCÉDÉ ET APPAREIL D'USINAGE

(30) Priority: 19.10.2016 IT 201600105300
(43) Date of publication of application: 28.08.2019
(73) Proprietor: Manz Italy S.r.l., 40037 Sasso Marconi (BO) (IT)
(72) Inventor: SALE, Massimiliano, 40037 Sasso Marconi (Bologna) (IT)
(74) Representative: Bergadano, Mirko
(86) International application number: PCT/IB2017/056358
(87) International publication number: WO 2018/073709

(56) References cited:
- WO-A1-2012/110915
- US-A- 5 799 858
- US-A1- 2007 228 539
- US-A1- 2007 284 759

## Description

### Background of the invention

The invention relates to a method and a machining apparatus, in particular for machining sheet material.

Specifically, but not exclusively, the invention may be applied to producing electric energy storing devices.

In particular, the present invention relates to machining material that advances with continuous motion along a supplying line.

Patent publication US 2007/284759 A1 discloses a machining apparatus as in the preamble of claim 1.

One of the problems that is found in the prior art, when it is desired to process material that is supplied continuously, is represented by the productivity of the process, which has technological limits linked, in particular, to the mass and acceleration of the mechanical components used in the machining, so that the continuous advancement speed cannot, in general, exceed certain thresholds.

### Summary of the invention

One object of the invention is to make an apparatus and/or a method that are suitable for machining material that advances continuously.

One object is to overcome the aforesaid limits and drawbacks of the prior art, permitting machining with high productivity.

One advantage is provide a machining method and apparatus that are usable in producing electric energy storing devices.

One advantage is make available a machining apparatus, for example a cutting/blanking apparatus, that is constructionally simple and cheap.

Such objects and advantages and still others are achieved by an apparatus and/or by a method according to one or more of the claims set out below.

In one embodiment, a machining apparatus comprises a supplying line, arranged for supplying material with continuous motion, and two or more machining units that are arranged one after the other along the supplying line and are each provided with an outward and return reciprocating movement and with an opening and closing movement with respect to the material, wherein each machining unit is capable of adopting the closed position (in which it processes the material) in at least one part of the outward stroke and the open position (in which it does not interfere in contact with the material) in the return stroke, and wherein each machining unit processes portions of material that are not processed by the other machining unit/s.

In particular, the material may be machined by the various machining units in such a manner that a portion of material machined by a machining unit can be comprised between two portions of material machined by another machining unit or other machining units. Each machining unit may be suitable, for example, for performing cutting and/or blanking, material removal, objects and/or material application, surface treatment, heat treatment, forming, etc.

In particular, the machining apparatus may comprise dragging means arranged for supplying the material with continuous motion along the supplying line, whereby the aforesaid machining units are not assigned to advancement of the material, as this function can be performed by dragging means that is distinct and separate from the machining units.

### Brief description of the drawings

The invention can be better understood and implemented with reference to the attached drawings that illustrate one embodiment thereof by way of non-limiting example of implementation, wherein:
Figure 1 shows a diagram of a machining apparatus made in accordance with the present invention;
Figures 2 to 6 show some steps in sequence of the operation of the machining apparatus in figure 1.

### Detailed description

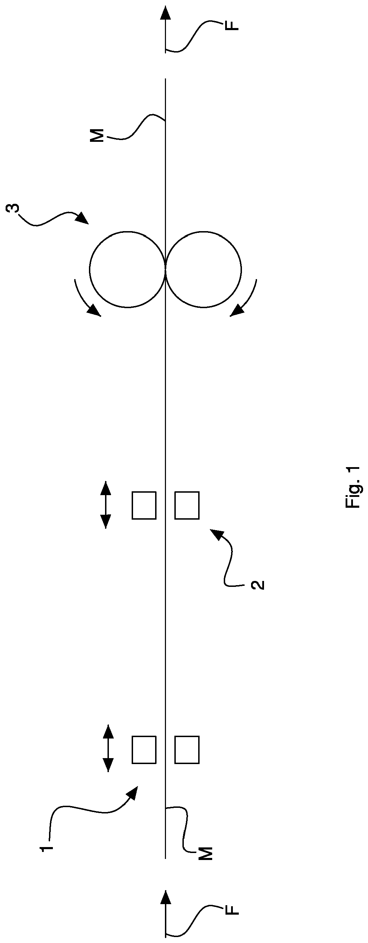

Figure 1 shows schematically a machining apparatus that is suitable for performing machining tasks on material advancing with continuous motion. The material may comprise, for example, material in continuous format (for example one or more continuous strips) or material in discrete format (for example several objects that advance one after the other). The machining apparatus may be used, in particular, to machine tape material (unwound from a reel). The machining apparatus may be used, for example, for the production of electric energy storing devices. The material to be machined that advances with continuous supplying motion may comprise, in particular, at least one separator for electrodes.

The machining apparatus may comprise, in particular, a supplying line arranged for continuously supplying material M in an advancement direction F. The material M being machined may advance, in particular, at a constant advancement speed. The supplying line may comprise, in particular, any supplying line of known type for supplying material with a continuous supplying motion, for example a supplying line comprising one or more of the following elements: a dragging system for a continuous tape (for example unwound from a reel); a mechanical conveyor, for example a belt, chain, roller, etc conveyor; a pneumatic conveyor; etc.

The machining apparatus may comprise, in particular, a first machining unit 1 of the material M arranged along the supplying line. The first machining unit 1 may be provided with a reciprocating movement with a cycle comprising an outward stroke and a return stroke along the supplying line. The outward stroke may comprise a movement in the advancement direction F. The return stroke may comprise a movement in the opposite direction. The first machining unit 1 may be provided with driving means (for example of known type) to perform the outward and return cycles. The driving means may comprise, in particular, a motorized system on guides (for example linear sliding guides).

The first machining unit 1 has the possibility of adopting a closed (work) position in which it can perform a machining task that modifies (by cutting, removing, deforming, etc) a portion of material and an open position (rest position in which it does not interfere with the material). In the closed position, the first machining unit 1 can interfere in contact with the material M. In the open position, the first machining unit 1 is able not to interfere in contact with the material, leaving the material free. The first machining unit 1 may be provided with driving means (for example of known type) to adopt selectively the closed position and the open position.

The first machining unit 1 may be controlled in such a manner as to adopt the (active) closed position in at least one part of the outward stroke and the (inactive) open position in at least one part of the return stroke.

The machining apparatus may comprise, in particular, a second machining unit 2 of the material arranged along the supplying line. The second machining unit 2 may be provided with a reciprocating movement with a cycle comprising an outward stroke and a return stroke along the supplying line. The outward stroke may comprise a movement in the advancement direction F. The return stroke may comprise a movement in an opposite direction. The second machining unit 2 may be provided with driving means to perform the outward and return cycles. The second machining unit 2 may be same as the first unit 1.

The second machining unit 2 has the possibility of adopting a closed (work) position in which it can perform a machining task that modifies a portion of material and an open (rest) position. In the closed position, the second machining unit 2 can interfere in contact with the material. In the open position, the second machining unit 2 is able not to interfere in contact with the material, leaving the material free. The second machining unit 2 may be provided with driving means to adopt selectively the closed position and the open position.

The second machining unit 2 may be controlled in such a manner as to adopt the closed (active) position in at least one part of the outward stroke and the open (inactive) position in at least one part of the return stroke.

The portions of material processed by the first and second machining units 1 and 2, and which are respectively indicated by 11, 12, 13, ... and 21, 22, ..., have been shown, for the sake of simplicity, by a wavy line.

Each machining unit 1 and 2 may comprise, for example, a pair of operating elements (for example tools) cooperating together, which are reciprocally movable, upon command, between the closed and open positions, such as for example a mould and counter mould pair, a blade and counter blade, punch and die, etc.

The machining apparatus may comprise, in particular, control means configured for controlling the first machining unit 1 in such a manner as to perform tasks on a succession of first portions of material 11, 12, 13, ..., spaced apart from one another along the advancement direction F. The control means may be configured for controlling the second machining unit 2 in such a manner as to perform tasks on a succession of second portions of material 21, 22, .., spaced apart from one another along the advancement direction F. The control means may comprise programmable electronic control means (for example an electronic processor) and computer programme instructions suitable for implementing a method for controlling the machining apparatus.

The control means may be configured, in particular, in such a manner that at least one first portion of material 11, 12, 13 (on which the first machining unit 1 operates) is different from the second portions of material 21, 22 (on which the second machining unit 2 operates). The control means may be configured, in particular, in such a manner that at least one second portion of material 21, 22 (on which the second machining unit 2 operates) is different from the first portions of material 11, 12, 13 (on which the first machining unit 1 operates). The control means may be configured, in particular, in such a manner that at least one second portion of material 21, 22 (on which the second machining unit 2 operates) is arranged between two first portions of material 11, 12, 13 (on which the first machining unit 1 operates). The control means may be configured, in particular, in such a manner that at least one first portion of material 11, 12, 13 (on which the first machining unit 1 operates) is arranged between two second portions of material 21, 22 (on which the second machining unit 2 operates). The control means may be configured, in particular, in such a manner that each of the first portions of material 11, 12, 13 (on which the first machining unit 1 operates) is spaced along the advancement direction F away from each of the second portions of material 21, 22 (on which the second machining unit 2 operates). The control means may be configured, in particular, so that the two machining units 1 and 2 can work at least partly the same portions of material.

The first machining unit 1 and the second machining unit 2 may be controlled by the aforesaid control means in a coordinated manner so that the duration of a work cycle of the first machining unit 1 is the same as the duration of a work cycle of the second machining unit 2. It is possible to provide for the duration of a work cycle of the first machining unit 1 being a multiple or submultiple of the duration of a work cycle of the second machining unit 2.

The first portions 11, 12, 13 may be spaced apart from one another at a constant pitch P. The second portions 21, 22 may be spaced apart from one another at a constant pitch, for example equal to the pitch P of the first portions. The first portions 11, 12, 13 may be arranged in an alternative manner to the second portions 21, 22. The first portions 11, 12, 13 may be spaced away from the second portions 21, 22 by a constant distance, for example the same as half the aforesaid pitch P of the first portions 11, 12, 13 and/or the second portions 21, 22.

The first machining unit 1 and the second machining unit 2 could be configured for performing the same type of machining task on the respective portions of material. The first machining unit 1 may be configured for performing one or more of the following machining tasks on the first portions 11, 12, 13: cutting/blanking, removing material, applying objects and/or material, surface treatment, heat treatment, forming, etc. The second machining unit 2 may be configured for performing one or more of the following machining tasks on the second portions 21, 22: cutting/blanking, removing material, applying objects and/or material, surface treatment, heat treatment, forming, etc.

The machining apparatus may comprise, in particular, dragging means 3 arranged for dragging the material M continuously along the supplying line in the advancement direction F. The dragging means 3 may comprise dragging means of the roller type, or dragging means with reciprocal motion (of the type disclosed in patent publication WO 2012/110915), or dragging means of other type (for example of known type).

The dragging means 3 may be arranged, in particular, after the first machining unit 1 and/or after the second machining unit 2, with reference to the advancement direction F.

The operation of the machining apparatus can implement a machining method. This machining method may comprise the step of supplying continuously the material M (continuous or discontinuous, for example continuous tape material) in an advancement direction F, for example at a constant speed.

This machining method may comprise the step of performing machining tasks on a succession of first portions of material 11, 12, 13, ..., spaced apart from one another (for example at a constant pitch P) by a first machining unit 1 that is movable with reciprocal motion with active outward strokes and inactive return strokes.

This machining method may comprise the step of performing tasks on a succession of second portions of material 21, 22, ..., spaced apart from one another (for example at a constant pitch P) by a second machining unit 2 that is movable with reciprocal motion with active outward strokes and inactive return strokes.

The second portions 21, 22, ..., may be different from the first portions 11, 12, 13, .... The second portions 21, 22, ..., may be spaced away from the first portions 11, 12, 13, ..., in the advancement direction F (for example by half the pitch P).

The control means may be configured in such a manner that each machining unit 1 and 2 adopts the closed (work) position during at least one part of the outward stroke, whilst the unit advances at the same speed as the material M. Each machining unit 1 and 2 will have, at the start of the outward stroke, a certain acceleration time before reaching the (constant) speed of the material M and will also have, at the end of the outward stroke, a certain deceleration time for stopping the stroke, so each machining unit 1 and 2, at each work cycle, in order to be able to be in the actual closed work position only when advancing at the same (constant) speed of the material M, will start to adopt the closed position (operating in actual contact with the material) after a certain time from the start of the outward stroke and will stop to adopt the closed position a certain time before the end of the outward stroke.

Each machining unit 1 and 2 will have, further, a higher average speed in the return stroke than in the outward stroke.

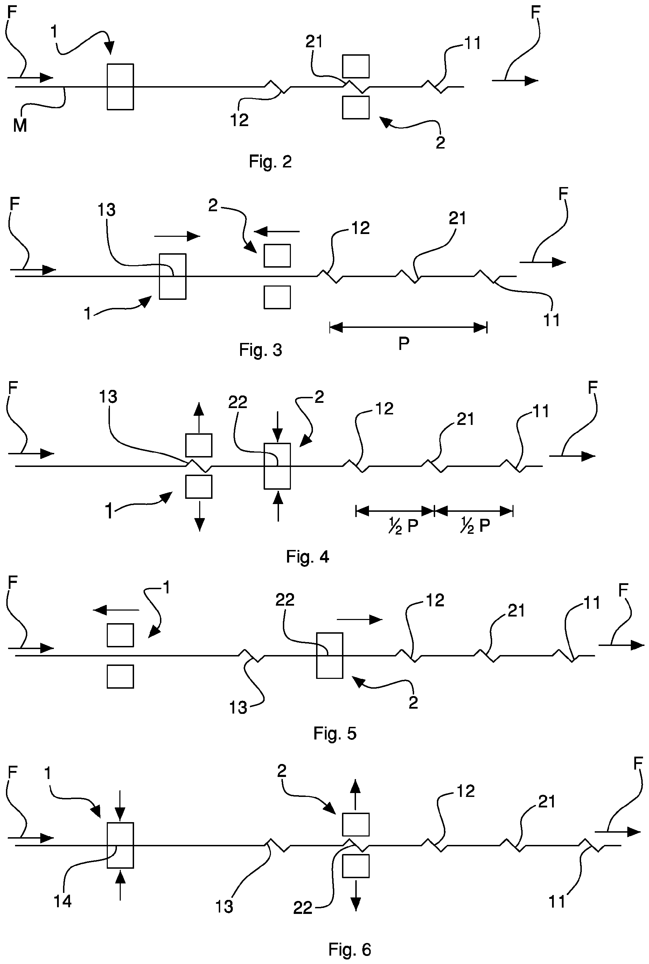

With reference to Figures 2 to 6, some steps in sequence are illustrated of one embodiment of a work cycle of the machining apparatus, starting from the configuration in figure 2 in which the first machining unit 1 is in a closed position at the start of the outward stroke and the second machining unit 2 is in the open position at the start of the return stroke. It should be observed that, in order to simplify the explanation, the times have not been considered that are necessary for the movements of opening and closing the machining units 1 and 2, nor the acceleration and deceleration times of the units in the outward and return motions (in particular at the start and at the end of the outward stroke). These times, as they are not nil, in reality have to be considered, with the consequence, for example, that each machining unit 1 and 2 will move to the closed position whilst it travels along an initial portion of the outward stroke and will return to the open position whilst it travels along a final portion of the outward stroke.

In this embodiment specific timing is shown of the work cycles of the two machining units 1 and 2, in which the start of the outward stroke of a unit occurs, substantially, at the start of the return stroke of the other unit. It is nevertheless possible to provide other timings, for example any timing.

In figure 3, the first machining unit 1 advances (outward stroke) in the closed position, performing the machining task on a first portion 13 of material, whereas the second machining unit 2 returns (return stroke) in the open position (of non-interference with the material) at an average speed that is greater than the outward stroke.

It is noted that, with reference to figures 2 and 3, the first machining unit 1 had already previously performed the machining task on at least two first portions 11 and 12 of material and that the second machining unit 2 had already previously performed the machining task on at least one second portion 21 of material.

In figure 4, the first machining unit 1 is in the open position at the start of the return stroke and the second machining unit 2 is in the closed position at the start of the outward stroke to perform the task on a second portion 22 of material. The second portion 22 of material may be half way between the two first portions 12 and 13 of material previously processed by the first machining unit 1.

In figure 5, the first machining unit 1 returns (return stroke) in the open (non-interference) position at an average speed that is greater than the outward stroke, whereas the second machining unit 2 advances (outward stroke) in the closed position, performing the machining task on the second portion 22 of material. When it is in the closed position, the second machining unit 2 can advance at the same advancement speed as the material M.

In figure 6 we have returned to the configuration in figure 2, closing the work cycle, with the first machining unit 1 again in the closed position at the start of the outward stroke to perform the task on the subsequent first portion 14 of material and the second machining unit 2 again in an open position at the start of the return stroke. The position of the first portion of material 14 may be selected in such a manner as to be located half way between the two second portions of material that will be subsequently processed by the second machining unit 2, after the second portion 22.

As said, the material M being machined may comprise material in continuous, or discrete, format. In the case of a continuous format, the machining units 1 and 2 may be configured in such a manner as to maintain the continuity of the material M (for example, machining may comprise blanking of a continuous tape without depriving the tape of continuity), or in such a manner as to deprive the material M of continuity, generating a plurality of discrete elements that advance with continuous motion.

The machining apparatus disclosed above comprises two machining units 1 and 2, although it is possible to envisage using three or more machining units.

## Claims

1. Machining apparatus comprising:
- a supplying line arranged for supplying material (M) with continuous motion in an advancement direction (F);
- a first machining unit (1) for machining the material arranged along said supplying line with the possibility of adopting a closed position in which it can perform machining tasks on a portion of material (M) and an open position in which it is possible for it not to interfere with the material (M);
- a second machining unit (2) for machining the material arranged along said supplying line with the possibility of adopting a closed position in which it can perform machining tasks on a portion of material (M) and an open position in which it is possible for it not to interfere with the material (M), said second machining unit (2) being arranged after said first machining unit (1) with reference to said advancement direction (F);
- control means configured for controlling said first machining unit (1) in such a manner as to machine a succession of first portions of material (11, 12, 13, ...) spaced apart from one another along said advancement direction (F) and for controlling said second machining unit (2) in such a manner as to machine a succession of second portions of material (21, 22, ...) spaced apart from one another along said advancement direction (F);
**characterized in that**:
- said first machining unit (1) is provided with a reciprocating movement with an outward stroke in said advancement direction (F) and a return stroke in an opposite direction, with the possibility of adopting said closed position in at least one part of the outward stroke and said open position in at least one part of the return stroke;
- said second machining unit (2) is provided with a reciprocating movement with an outward stroke in said advancement direction (F) and a return stroke in an opposite direction, with the possibility of adopting said closed position in at least one part of the outward stroke and said open position in at least one part of the return stroke.

2. Apparatus according to claim 1, wherein said control means is configured in such a manner that at least one first portion of material (11, 12, 13, ...) is different from the second portions of material (21, 22, ...).

3. Apparatus according to claim 1 or 2, wherein said control means is configured in such a manner that at least one second portion of material (21, 22, ...) is different from the first portions of material (11, 12, 13, ...).

4. Apparatus according to any preceding claim, wherein said control means is configured in such a manner that at least one second portion of material (21, 22, ...) is arranged between two first portions of material (11, 12, 13, ...).

5. Apparatus according to any preceding claim, wherein said control means is configured in such a manner that at least one first portion of material (11, 12, 13, ...) is arranged between two second portions of material (21, 22, ...).

6. Apparatus according to any preceding claim, wherein said control means is configured in such a manner that each first portion of material (11, 12, 13, ...) is spaced along said advancement direction (F) from each of the second portions of material (21, 22, ...).

7. Apparatus according to claim 6, wherein the first portions of material (11, 12, 13, ...) are spaced apart from one another at a constant pitch (P) and the second portions of material (21, 22, ...) are spaced apart from one another at said constant pitch (P).

8. Apparatus according to claim 7, wherein the first portions of material (11, 12, 13, ...) and the second portions of material (21, 22, ...) are arranged alternately between themselves at a reciprocal distance that is equal to half said pitch (P).

9. Apparatus according to any preceding claim, wherein said first machining unit (1) and said second machining unit (2) are configured for performing the same machining tasks on the respective portions of material.

10. Apparatus according to any preceding claim, wherein said first machining unit (1) and/or said second machining unit (2) are configured for performing one or more of the following machining tasks on the respective portions of material: cutting/blanking, removal of material, applying objects and/or material, surface treatment, heat treatment, forming.

11. Apparatus according to any preceding claim, comprising dragging means (3) arranged for dragging the material (M) with continuous motion along said supplying line in said advancement direction (F).

12. Apparatus according to claim 11, wherein said dragging means (3) is arranged after said first and second machining units (1 and 2) with reference to said advancement direction (F).

13. Use of an apparatus according to any preceding claim for producing electric energy storing devices.

14. Machining method comprising the steps of:
- supplying material (M) in an advancement direction (F) with a continuous supply motion;
- performing machining tasks on a succession of first portions (11, 12, 13, ...) of said material (M) by a first machining unit (1) that is movable with reciprocating movement with outward strokes and return strokes;
- performing machining tasks on a succession of second portions (21, 22, ...) of said material (M) by a second machining unit (2) that is movable with reciprocating movement with outward strokes and return strokes, said second portions (21, 22, ...) being at least partly different from said first portions (11, 12, 13, ...), each second portion (21, 22, ...) being at least partly spaced away from each first portion (11, 12, 13, ...) in said advancement direction (F).

## Patentansprüche

1. Bearbeitungsvorrichtung, die aufweist:
- eine Zuführlinie, die zum Zuführen von Material (M) mittels einer kontinuierlichen Bewegung in einer Vorschubrichtung (F) vorgesehen ist;
- eine erste Bearbeitungseinheit (1) zum Bearbeiten des Materials, das entlang der Zuführlinie angeordnet ist, mit der Möglichkeit des Einnehmens einer geschlossenen Position, in der sie Bearbeitungsaufgaben an einem Abschnitt des Materials (M) durchführen kann, und einer offenen Position, in der es möglich ist, dass sie nicht mit dem Material (M) interferiert;
- eine zweite Bearbeitungseinheit (2) zum Bearbeiten des Materials, das entlang der Zuführlinie angeordnet ist, mit der Möglichkeit des Einnehmens einer geschlossenen Position, in der sie Bearbeitungsaufgaben an einem Abschnitt des Materials (M) durchführen kann, und einer offenen Position, in der es möglich ist, dass sie nicht mit dem Material (M) interferiert, wobei die zweite Bearbeitungseinheit (2) relativ zu der Vorschubrichtung (F) hinter der ersten Bearbeitungseinheit (1) angeordnet ist;
- eine Steuereinrichtung, die zum Steuern der ersten Bearbeitungseinheit (1) derart, dass diese eine Abfolge von ersten Abschnitten des Materials (11, 12, 13, ...), die in der Vorschubrichtung (F) voneinander beabstandet sind, bearbeitet, und der zweiten Bearbeitungseinheit (2) derart, dass diese eine Abfolge von zweiten Abschnitten des Materials (21, 22, ...), die in der Vorschubrichtung (F) voneinander beabstandet sind, ausgebildet ist;
**dadurch gekennzeichnet, dass**:
- die erste Bearbeitungseinheit (1) eine Hin- und Herbewegung mit einem in der Vorschubrichtung (F) nach außen gerichteten Hub und einem Rückhub in einer entgegengesetzten Richtung aufweist, mit der Möglichkeit des Einnehmens der geschlossenen Position bei mindestens einem Teil des nach außen gerichteten Hubs und der offenen Position bei mindestens einem Teil des Rückhubs;
- die zweite Bearbeitungseinheit (2) eine Hin- und Herbewegung mit einem in der Vorschubrichtung (F) nach außen gerichteten Hub und einem Rückhub in einer entgegengesetzten Richtung aufweist, mit der Möglichkeit des Einnehmens der geschlossenen Position bei mindestens einem Teil des nach außen gerichteten Hubs und der offenen Position bei mindestens einem Teil des Rückhubs.

2. Vorrichtung nach Anspruch 1, bei der die Steuereinrichtung derart ausgebildet ist, dass sich mindestens ein erster Abschnitt des Materials (11, 12, 13, ...) von den zweiten Abschnitten des Materials (21, 22, ...) unterscheidet.

3. Vorrichtung nach Anspruch 1 oder 2, bei der die Steuereinrichtung derart ausgebildet ist, dass sich mindestens ein zweiter Abschnitt des Materials (21, 22, ...) von den ersten Abschnitten des Materials (11, 12, 13, ...) unterscheidet.

4. Vorrichtung nach einem der vorhergehenden Ansprüche, bei der die Steuereinrichtung derart ausgebildet ist, dass mindestens ein zweiter Abschnitt des Materials (21, 22, ...) zwischen zwei ersten Abschnitten des Materials (11, 12, 13, ...) angeordnet ist.

5. Vorrichtung nach einem der vorhergehenden Ansprüche, bei der die Steuereinheit derart ausgebildet ist, dass mindestens ein erster Abschnitt des Materials (11, 12, 13, ...) zwischen zwei zweiten Abschnitten des Materials (21, 22, ...) angeordnet ist.

6. Vorrichtung nach einem der vorhergehenden Ansprüche, bei der die Steuereinrichtung derart ausgebildet ist, dass jeder erste Abschnitt des Materials (11, 12, 13, ...) in der Vorschubrichtung (F) von jedem der zweiten Abschnitte des Materials (21, 22, ...) beabstandet ist.

7. Vorrichtung nach Anspruch 6, bei der die ersten Abschnitte des Materials (11, 12, 13, ...) in einer konstanten Teilung (P) voneinander beabstandet sind und die zweiten Abschnitte des Materials (21, 22, ...) in der konstanten Teilung (P) voneinander beabstandet sind.

8. Vorrichtung nach Anspruch 7, bei der die ersten Abschnitte des Materials (11, 12, 13, ...) und die zweiten Abschnitte des Materials (21, 22, ...) alternierend zwischen sich in einem reziproken Abstand, der die Hälfte der Teilung (P) ist, angeordnet sind.

9. Vorrichtung nach einem der vorhergehenden Ansprüche, bei der die erste Bearbeitungseinheit (1) und die zweite Bearbeitungseinheit (2) zum Durchführen der gleichen Bearbeitungsaufgaben an den jeweiligen Abschnitten des Materials ausgebildet sind.

10. Vorrichtung nach einem der vorhergehenden Ansprüche, bei der die erste Bearbeitungseinheit (1) und/oder die zweite Bearbeitungseinheit (2) zum Durchführen einer oder mehrerer der folgenden Bearbeitungsaufgaben an den jeweiligen Abschnitten des Materials ausgebildet sind: Schneiden/Stanzen, Entfernen von Material, Aufbringen von Objekten und/oder Material, Oberflächenbehandlung, Wärmebehandlung, Formen.

11. Vorrichtung nach einem der vorhergehenden Ansprüche, die eine Zieheinrichtung (3) aufweist, die zum Ziehen des Materials (M) mittels einer kontinuierlichen Bewegung in der Vorschubrichtung (F) entlang der Zuführlinie vorgesehen ist.

12. Vorrichtung nach Anspruch 11, bei der die Zieheinrichtung (3) relativ zu der Vorschubrichtung (F) hinter der ersten und der zweiten Bearbeitungseinheit (1 und 2) angeordnet ist.

13. Verwendung einer Vorrichtung nach einem der vorhergehenden Ansprüche zum Herstellen von Elektroenergiespeichervorrichtungen.

14. Bearbeitungsverfahren, das die folgenden Schritte umfasst:
- Zuführen von Material (M) in einer Vorschubrichtung (F) mittels einer kontinuierlichen Zuführbewegung;
- Durchführen von Bearbeitungsaufgaben an einer Abfolge von ersten Abschnitten (11, 12, 13, ...) des Materials (M) durch eine erste Bearbeitungseinheit (1), die mittels einer Hin- und Herbewegung mit nach außen gerichteten Hüben und Rückhüben bewegbar ist;
- Durchführen von Bearbeitungsaufgaben an einer Abfolge von zweiten Abschnitten (21, 22, ...) des Materials (M) durch eine zweite Bearbeitungseinheit (2), die mittels einer Hin- und Herbewegung mit nach außen gerichteten Hüben und Rückhüben bewegbar ist, wobei sich die zweiten Abschnitte (21, 22, ...) zumindest teilweise von den ersten Abschnitten (11, 12, 13, ...) unterscheiden, wobei jeder zweite Abschnitt (21, 22, ...) in der Vorschubrichtung (F) zumindest teilweise von jedem ersten Abschnitt (11, 12, 13, ...) beabstandet ist.

## Revendications

1. Appareil d'usinage comprenant :
- une ligne d'alimentation agencée pour une alimentation en matériau (M) avec un mouvement continu dans une direction d'avancement (F) ;
- une première unité d'usinage (1) pour usiner le matériau, agencée le long de ladite ligne d'alimentation avec la possibilité d'adopter une position fermée dans laquelle elle peut réaliser des tâches d'usinage sur une partie de matériau (M) et une position ouverte dans laquelle il est possible pour elle de ne pas interférer avec le matériau (M) ;
- une seconde unité d'usinage (2) pour usiner le matériau, agencée le long de ladite ligne d'alimentation avec la possibilité d'adopter une position fermée dans laquelle elle peut réaliser des tâches d'usinage sur une partie de matériau (M) et une position ouverte dans laquelle il est possible pour elle de ne pas interférer avec le matériau (M), ladite seconde unité d'usinage (2) étant agencée après ladite première unité d'usinage (1) en référence à ladite direction d'avancement (F) ;
- un moyen de commande configuré pour commander ladite première unité d'usinage (1) de manière à usiner une succession de premières parties de matériau (11, 12, 13, ...) espacées les unes des autres le long de ladite direction d'avancement (F) et pour commander ladite seconde unité d'usinage (2) de manière à usiner une succession de secondes parties de matériau (21, 22, ...) espacées les unes des autres le long de ladite direction d'avancement (F) ;
**caractérisé en ce que** :
- ladite première unité d'usinage (1) est pourvue d'un mouvement de va-et-vient avec une course aller dans ladite direction d'avancement (F) et une course de retour dans une direction opposée, avec la possibilité d'adopter ladite position fermée dans au moins une partie de la course aller et ladite position ouverte dans au moins une partie de la course de retour ;
- ladite seconde unité d'usinage (2) est pourvue d'un mouvement de va-et-vient avec une course aller dans ladite direction d'avancement (F) et une course de retour dans une direction opposée, avec la possibilité d'adopter ladite position fermée dans au moins une partie de la course aller et ladite position ouverte dans au moins une partie de la course de retour.

2. Appareil selon la revendication 1, ledit moyen de commande étant configuré de telle manière qu'au moins une première partie de matériau (11, 12, 13, ...) est différente des secondes parties de matériau (21, 22, ...).

3. Appareil selon la revendication 1 ou 2, ledit moyen de commande étant configuré de telle manière qu'au moins une seconde partie de matériau (21, 22, ...) est différente des premières parties de matériau (11, 12, 13, ...).

4. Appareil selon l'une quelconque des revendications précédentes, ledit moyen de commande étant configuré de telle manière qu'au moins une seconde partie de matériau (21, 22, ...) est agencée entre deux premières parties de matériau (11, 12, 13, ...) .

5. Appareil selon l'une quelconque des revendications précédentes, ledit moyen de commande étant configuré de telle manière qu'au moins une première partie de matériau (11, 12, 13, ...) est agencée entre deux secondes parties de matériau (21, 22, ...) .

6. Appareil selon l'une quelconque des revendications précédentes, ledit moyen de commande étant configuré de telle manière que chaque première partie de matériau (11, 12, 13, ...) est espacée le long de ladite direction d'avancement (F) par rapport à chacune des secondes parties de matériau (21, 22, ...) .

7. Appareil selon la revendication 6, les premières parties de matériau (11, 12, 13, ...) étant espacées les unes des autres à un pas constant (P) et les secondes parties de matériau (21, 22, ...) étant espacées les unes des autres audit pas constant (P).

8. Appareil selon la revendication 7, les premières parties de matériau (11, 12, 13, ...) et les secondes parties de matériau (21, 22, ...) étant agencées en alternance entre elles à une distance réciproque qui est égale à la moitié dudit pas (P).

9. Appareil selon l'une quelconque des revendications précédentes, ladite première unité d'usinage (1) et ladite seconde unité d'usinage (2) étant configurées pour réaliser les mêmes tâches d'usinage sur les parties respectives de matériau.

10. Appareil selon l'une quelconque des revendications précédentes, ladite première unité d'usinage (1) et/ou ladite seconde unité d'usinage (2) étant configurées pour réaliser une ou plusieurs des tâches d'usinage suivantes sur les parties respectives de matériau : coupage/découpage, élimination de matériau, application d'objets et/ou de matériau, traitement de surface, traitement thermique, formage.

11. Appareil selon l'une quelconque des revendications précédentes, comprenant un moyen d'entraînement (3) agencé pour entraîner le matériau (M) avec un mouvement continu le long de ladite ligne d'alimentation dans ladite direction d'avancement (F).

12. Appareil selon la revendication 11, ledit moyen d'entraînement (3) étant agencé après lesdites première et seconde unités d'usinage (1 et 2) en référence à ladite direction d'avancement (F).

13. Utilisation d'un appareil selon l'une quelconque des revendications précédentes pour la production de dispositifs de stockage d'énergie électrique.

14. Procédé d'usinage comprenant les étapes de :
- l'alimentation en matériau (M) dans une direction d'avancement (F) avec un mouvement d'alimentation continu ;
- la réalisation de tâches d'usinage sur une succession de premières parties (11, 12, 13, ...) dudit matériau (M) par une première unité d'usinage (1) qui est mobile avec un mouvement de va-et-vient avec des courses aller et des courses de retour ;
- la réalisation de tâches d'usinage sur une succession de secondes parties (21, 22, ...) dudit matériau (M) par une seconde unité d'usinage (2) qui est mobile avec un mouvement de va-et-vient avec des courses aller et des courses de retour, lesdites secondes parties (21, 22, ...) étant au moins partiellement différentes desdites premières parties (11, 12, 13, ...), chaque seconde partie (21, 22, ...) étant au moins partiellement espacée par rapport à chaque première partie (11, 12, 13, ...) dans ladite direction d'avancement (F).
